# FASCICULE DE BREVET EUROPEEN

(11) **EP 0 678 802 B1**
(45) Date de publication et mention de la délivrance du brevet: **20.11.1996**
(21) Numéro de dépôt: 95470015.9
(22) Date de dépôt: 14.04.1995
(51) Int. Cl.: G05F 3/24, G11C 16/06

(54) **Circuit de limitation de tension avec comparateur à hystérésis**
Schaltungsanordnung zur Spannungsbegrenzung mit Hysteresiskomparator
Circuit for voltage limiting with hysteresis comparator

(30) Priorité: 21.04.1994 FR 9404984
(43) Date de publication de la demande: 25.10.1995
(73) Titulaire: SGS-THOMSON MICROELECTRONICS S.A., F-94250 Gentilly (FR)
(72) Inventeur: Drouot, Sylvie, F-57000 Metz (FR)
(74) Mandataire: Schmit, Christian Norbert Marie

(56) Documents cités:
- EP-A- 0 382 929
- WO-A-93/05513
- FR-A- 2 667 169

## Description

L'invention concerne un circuit de limitation de tension. Plus particulièrement, elle concerne un circuit de limitation de tension pour maintenir une tension produite par un générateur de tension tels qu'on en trouve dans les mémoires électriquement programmables en circuit intégré.

Pour programmer ces mémoires, il est généralement nécessaire de disposer dans le circuit intégré d'une tension dite de programmation, VG, qui est supérieure à la tension d'alimentation normale VCC du circuit. Par exemple, VCC est couramment égale à 5 volts et VB à 7 volts au plus.

Dans certaines mémoires, la tension de programmation VB est fournie à l'intérieur du circuit intégré, à partir de la tension d'alimentation normale VCC. On utilise pour cela un circuit multiplicateur de tension, appelé également pompe de charge, qui reçoit VCC et établit une tension VB supérieure à VCC.

Les circuits multiplicateurs de tension utilisent à la base tout simplement des diodes, deux capacités et un signal d'horloge. Dans un premier temps, on charge la première capacité à VCC, puis on la décharge dans la deuxième. Puis on recommence la même opération et la tension aux bornes du second condensateur augmente progressivement.

La tension de programmation va tendre ainsi asymptotiquement vers une valeur limite, cette valeur limite étant égale à un multiple de la tension d'alimentation VCC (deux fois VCC dans l'exemple décrit précédemment).

Ce type de montage pose un problème si la tension que l'on souhaite atteindre a la valeur limite. En effet, la tension produite augmente de moins en moins rapidement au fur et à mesure que le deuxième condensateur se charge. Pour limiter le temps d'établissement de la tension produite à la valeur souhaitée, on est donc amené à surdimensionner la pompe de charge. Ainsi, on fixe une valeur limite supérieure à la valeur souhaitée. Il est alors nécessaire de placer en sortie de la pompe un régulateur de tension qui limite la tension produite à la valeur souhaitée. Par ailleurs, si la valeur souhaitée n'est pas un multiple de la valeur de la tension d'alimentation, la présence d'un tel circuit régulateur s'impose logiquement.

Il existe deux manières de limiter la tension produite :
- sans arrêter la pompe, en consommant la surcharge fournie par la pompe, une fois la valeur souhaitée atteinte, en connectant la sortie de la pompe à une masse par le biais d'une ou plusieurs diodes par exemple,
- en arrêtant la pompe lorsque la valeur souhaitée est atteinte et en la redémarrant lorsque la tension aux bornes du second condensateur devient trop basse (ce qui suppose que l'on accepte que la tension produite soit comprise dans une certaine plage de valeurs alors que dans le premier cas, cette tension sera constante).

La deuxième solution a l'avantage de consommer moins mais nécessite pratiquement de produire deux tensions de références et d'utiliser deux circuits de comparaison pour comparer ces tensions de référence aux valeurs maximales et minimales acceptables. Pour produire les tensions de référence, on emploie typiquement des diodes Zener. La deuxième solution est donc pénalisante d'un point de vue encombrement et d'un point de vue économique.

La demande de brevet WO-A-93 05513 décrit une pompe de charge possédant un circuit de régulation de tension et un circuit d'arrêt de pompe et de régulation comme décrit dans l'art antérieur de l'invention. L'invention cherche à résoudre le problème de surface causé par un tel dispositif.

La demande de brevet FR-A-2 667 169 décrit une pompe de charge avec régulation de la sortie de la pompe comme décrit dans l'art antérieur de l'invention.

La demande de brevet EP-A-0 382 929 décrit une pompe de charge avec un régulateur à forte consommation comme décrit dans l'art antérieur de l'invention.

L'invention a pour but de proposer un circuit qui mette en oeuvre la deuxième solution et qui soit suffisamment peu encombrant et peu onéreux. Au lieu d'employer deux circuits pour comparer la valeur de la tension disponible à deux valeurs de référence distinctes, l'invention propose un seul circuit de régulation qui met en oeuvre un comparateur de tension à hystérésis.

Pour cela, on propose un circuit intégré comprenant un circuit d'alimentation fournissant sur une sortie une tension interne, et un circuit de limitation de tension, caractérisé en ce que le circuit de limitation de tension comprend :
- des moyens résistifs pour produire un courant de référence proportionnel à la tension interne,
- une source de tension commandée en courant pour produire une tension de référence proportionnelle au courant de référence,
- un comparateur à hystérésis recevant la tension de référence sur une entrée et fournissant un signal binaire sur une sortie tel que ce signal passe dans un premier état quand la tension interne atteint une valeur maximale et que ce signal passe dans un second état si la tension interne atteint ultérieurement une valeur minimale.

Les moyens résistifs comportent de préférence une résistance connectée à la sortie du circuit d'alimentation, un premier transistor d'amplification monté en série entre cette résistance et une borne de référence, et un deuxième transistor d'amplification formant avec le premier transistor d'amplification un miroir de courant pour produire le courant de référence de telle manière que celui-ci soit proportionnel au courant traversant la résistance.

Ainsi, une chaîne résistive est connectée sur la sortie de la pompe de charge. Un courant est donc prélevé sur la sortie de la pompe et recopié par un miroir de courant. Cela permet de prélever un courant faible, ce qui limite la consommation globale du circuit et évite que le temps de montée de la tension produite par la pompe n'augmente de manière trop importante. En effet, les pompes de charge ont un temps de montée d'autant plus court que la charge en sortie est plus capacitive.

Dans le but de limiter la consommation, la chaîne résistive sera de préférence réalisée de telle manière que le courant prélevé sera nul quand la tension produite par la pompe de charge sera inférieure à un certain seuil. La source de tension de référence comportera de préférence au moins une résistance de référence montée en série entre une borne d'alimentation et le deuxième transistor du miroir de courant. On produira ainsi une tension de référence accessible au point milieu de cette résistance et de ce transistor.

D'autres caractéristiques et avantages de l'invention apparaîtront à la lecture de la description détaillée qui suit et qui est fait en référence aux dessins annexés dans lesquels :
- la figure 1 représente un mode de réalisation de l'invention,
- les figures 2a à 2d représentent des chronogrammes de signaux électriques correspondant au circuit de la figure 1.

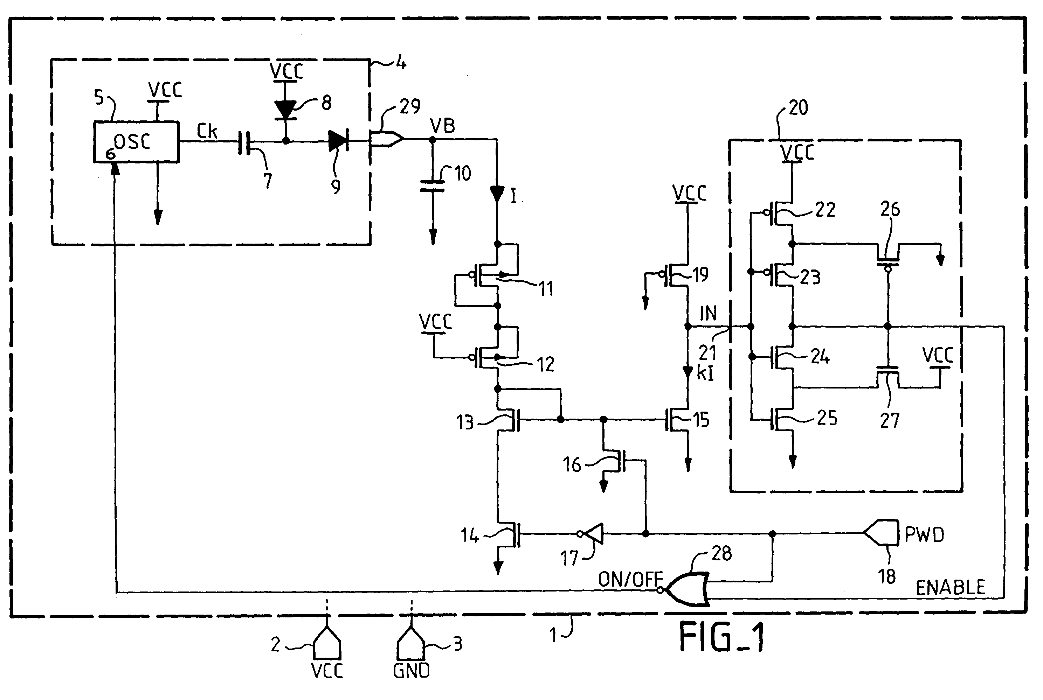

La figure 1 représente un circuit intégré 1 comprenant :
- une borne d'alimentation 2 pour fournir une tension d'alimentation VCC,
- une borne de référence 3 pour fournir une tension de base GND,
- une pompe de charge 4 pour produire une tension interne VB à partir de la tension d'alimentation VCC, et qui soit supérieure à cette tension d'alimentation VCC.

Dans un exemple, VCC vaut 3 volts, la borne de référence 3 est une masse, et la tension VB souhaitée est comprise entre 4,9 et 5,4 volts.

On notera que la description détaillée est faite en référence à une application avantageuse dans un circuit intégré de type mémoire électriquement programmable. Il ne s'agit bien sûr que d'un exemple particulier, un circuit de limitation défini suivant l'invention pouvant très bien être utilisé pour limiter une tension produite par un circuit d'alimentation non implanté sur un même circuit intégré. De même, le circuit de limitation tel que décrit pourra très bien être réalisé en composants discrets sans que l'on sorte du cadre de l'invention.

On se contentera donc d'une pompe de charge 4 qui double la tension d'alimentation VCC. Cette pompe 4 comporte un oscillateur 5 pour fournir un signal d'horloge CK. Ce signal est appliqué à une borne d'un condensateur 7. L'autre borne de ce condensateur 7 est connectée d'une part à la borne d'alimentation 2 par le biais d'une diode 8, et d'autre part à une sortie 29 par le biais d'une diode 9. Cette borne de sortie 29 est connectée à la première borne d'une condensateur de sortie 10. Le condensateur de sortie 10 a son autre borne connectée à la borne de référence 3.

On considère ici que le condensateur de sortie 10 constitue l'équivalent d'un circuit capacitif alimenté par la pompe de charge 4, ce qui explique que cette pompe ne comprend qu'un seul condensateur 7. La tension interne VB est la tension présente sur la sortie 29 de la pompe de charge 4.

Pour arrêter la pompe de charge 4, on suppose que l'oscillateur 5 comprend une entrée 6 pour recevoir un signal logique ON/OFF de telle manière que l'oscillateur 7 fonctionne si ON/OFF est à l'état logique 1 et s'arrête s'il est à l'état logique 0. Si ON/OFF = 1, le signal d'horloge CK sera constant et au potentiel de la masse et ne pourra donc pas charger le condensateur 7.

La sortie 29 est connectée à la source d'un premier transistor de type P 11. Ce transistor 11 a sa grille de commande connectée à son drain. Il est donc monté en diode. D'autre part, en supposant que le circuit intégré 1 est réalisé sur substrat P, on connectera le caisson du transistor 11 à sa source. Cela permet d'avoir une tension de seuil plus stable et relativement faible (suppression de l'effet dit "de substrat" sur la tension de seuil).

Le drain du premier transistor de type P 11 est connecté à la source d'un deuxième transistor de type P 12. De même que pour le premier transistor de type P 11, le deuxième transistor de type P 12 a son caisson connecté à sa source. La grille de commande de ce deuxième transistor 12 est connectée à la borne d'alimentation 2 et reçoit donc VCC.

Le drain du deuxième transistor de type P 12 est connecté au drain et à la grille de commande d'un premier transistor d'amplification 13 de type N. La grille de commande de ce premier transistor d'amplification 13 est connectée à la grille de commande d'un second transistor d'amplification de type N 15, et l'ensemble de ces transistors d'amplification forme un miroir de courant.

La source du premier transistor d'amplification 13 est connectée à la masse par le biais d'un premier transistor d'isolation de type N 14. Par ailleurs, les grilles de commande des transistors d'amplification 13 et 15 sont connectées à la masse par le biais d'un deuxième transistor d'isolation 16. La grille de commande de ce deuxième transistor d'isolation 16 est connectée à une borne de commande 18 et reçoit un signal de commande de limitation binaire PWD. La borne de commande 18 est connectée à l'entrée d'un inverseur 17 dont la sortie est connectée à la grille de commande du premier transistor d'isolation 14.

La source du deuxième transistor d'amplification 15 est connectée à la masse 3. Son drain est connecté au drain d'un transistor de référence de type P 19 dont la source est connectée à la borne d'alimentation 2.

La grille de commande de ce transistor de référence 19 est connectée à la masse 3.

On supposera tout d'abord que PWD = 0. Le premier transistor d'isolation 14 est donc passant et le deuxième transistor d'isolation 15 est bloqué.

Si le signal logique ON/OFF passe de 0 à 1, alors l'oscillateur va fonctionner et la tension interne VB va peu à peu augmenter. En supposant que le premier et le deuxième transistors de type P 11 et 12 ont une tension de seuil identique Vtp, un courant I va circuler dans ces transistors dès que VB sera supérieur à VCC + 2 ∗ Vtp. En supposant Vtp égal à 1 volt, alors le courant I va circuler dans les transistors 11 et 12 dès qu'on aura VB égal à 4 volts (avec VCC égal à 3 volts).

Ce courant I va être recopié par le miroir de courant et un courant kI (en notant k le gain du miroir de courant) appelé courant de référence va circuler dans le transistor de référence 19 qui se comporte comme une résistance de référence de valeur R. L'ensemble formé par le miroir de courant, le transistor de référence 19 et la borne d'alimentation 2 se comporte comme une source de tension commandée en courant qui fournit une tension de référence IN = VCC - R. kI accessible au niveau du drain du transistor de référence 19.

De préférence, le deuxième transistor P 12 et le transistor de référence 19 seront résistifs.

On choisira par exemple un rapport W/L (largeur de grille exprimée en micromètres sur longueur de grille exprimée en micromètres) de 3/30 pour le deuxième transistor P 12 et des 3/80 pour le transistor de référence 19.
Ainsi, le courant I traversant le deuxième transistor P 12 pourra valoir 0.5 à 1 micro-ampère. On ne prélevera pas un courant important sur le condensateur de sortie 10 et le temps de monté de la tension interne VB n'augmentera pas significativement (par rapport au temps de montée si seul le condensateur de sortie 10 est connecté à la sortie 29 de la pompe de charge 4).

Par ailleurs, en fixant W/L = 3/10 pour le premier transistor d'amplification 13 et W/L = 3/1 pour le deuxième transistor d'amplification 15, on obtiendra un gain k = 10 pour le miroir de courant. Ce gain important permettra de produire une tension de référence IN variant beaucoup en fonction du courant prélevé I, le transistor de référence 19 étant par ailleurs résistif.

La tension de référence IN est fournie à une entrée 21 d'un comparateur à hystérésis 20. Le comparateur à hystérésis a donc son entrée connectée au point milieu du deuxième transistor d'amplification et de la résistance de référence montés en série.

Le comparateur à hystérésis 20 comprend :
- un premier transistor de type P 22 dont la source est connectée à la borne d'alimentation 2 et dont la grille de commande est connectée à l'entrée 21,
- un deuxième transistor de type P 23 ayant sa source connectée au drain du premier transistor de type P 22, et sa grille de commande connectée à l'entrée 21,
- un premier transistor de type N 24 ayant son drain connecté au drain du deuxième transistor de type P 23, et sa grille de commande connectée à l'entrée 21,
- un deuxième transistor de type N 25 ayant son drain connecté à la source du premier transistor de type N 24, sa grille de commande connectée à l'entrée 21, et sa source connectée à la masse,
- un troisième transistor de type P 26 ayant sa source connectée à la masse, son drain connecté à la source du deuxième transistor de type P 23, et sa grille de commande connectée au drain de ce deuxième transistor 23, et
- un troisième transistor de type N 27 ayant sa source connectée à la borne d'alimentation 2, son drain connecté à la source du premier transistor de type N 24, et sa grille de commande connectée au drain de ce premier transistor 24.

Le point milieu du deuxième transistor de type P 23 et du premier transistor de type N 24 correspond à la sortie du comparateur à hystérésis et fournit un signal binaire ENABLE.

Quand aucun courant I ne circule dans la branche résistive connectée à la sortie 29, le premier et le deuxième transistor de type N 24 et 25 sont passants et le troisième transistor de type N 27 est bloqué. Le signal ENABLE est alors à 0. D'un autre côté, le troisième transistor de type P 26 est passant et le deuxième transistor de type P 23, qui est bloqué, a sa source à la masse et sa grille de commande à VCC.

Quand le courant I commence à circuler dans la branche résistive, la tension de référence IN commence à chuter. Les premiers et deuxième transistors de type P 22 et 23 ont donc tendance à devenir passants. Néanmoins, la présence du troisième transistor de type P 26 tend à augmenter leur tension de seuil et la tension de basculement se déplace donc vers le bas.

De même, le troisième transistor de type N 27 a tendance à augmenter la tension de seuil des premiers et deuxième transistors de type N 24 et 25 quand la tension de référence va augmenter.

On aura donc deux valeurs de tension de référence différentes pour rendre les transistors P ou les transistors N passants.

Moins les troisièmes transistors de type N 27 et de type P 26 seront résistifs, plus on déplacera les valeurs de référence provoquant un basculement vers le haut et vers le bas.

On pourra par exemple fixer une valeur de tension de référence INM de 2,3 volts pour rendre les transistors de type N 24 et N 25 passants et une valeur de tension de référence INm de 0,7 volts pour rendre les transistors de type P 22 et 23 passants.

La valeur de la tension de référence IN étant fonction de la tension interne VB, on produira donc un signal binaire ENABLE passant de 0 à 1 pour une valeur maximale VBM de VB et passant de 1 à 0 pour une valeur minimale VBm de VB (par exemple VBM = 5,4 volts et VBm = 4,0 volts).

La sortie du comparateur à hystérésis est connectée à une entrée d'une porte NON OU 28 à deux entrées. L'autre entrée de cette porte NON OU 28 reçoit le signal de commande de limitation PWD. La sortie de la porte NON OU 28 est connectée à l'entrée 6 de l'oscillateur 5 et lui fournit donc le signal logique ON/OFF.

Tant que PWD = 0, le signal ON/OFF suit les variations du signal binaire ENABLE, son état étant inversé par rapport à celui du signal ENABLE.

Si on veut arrêter l'ensemble de la pompe de charge 4 et du circuit de limitation de courant, il suffit de mettre PWD à 1. Ainsi, le signal ON/OFF passe à 0 et l'oscillateur est arrêté. D'autre part, le premier transistor d'isolation 14 va être bloqué alors que le deuxième transistor d'isolation 16 va devenir passant. Aucun courant ne circulera donc plus dans la branche résistive et dans le transistor de référence 19.

Le condensateur de sortie 10 restera ainsi chargé. Cette possibilité de diminution de la consommation est particulièrement intéressante si on souhaite utiliser un mode de basse consommation tout en se ménageant la possibilité de revenir rapidement à un état opérationnel.

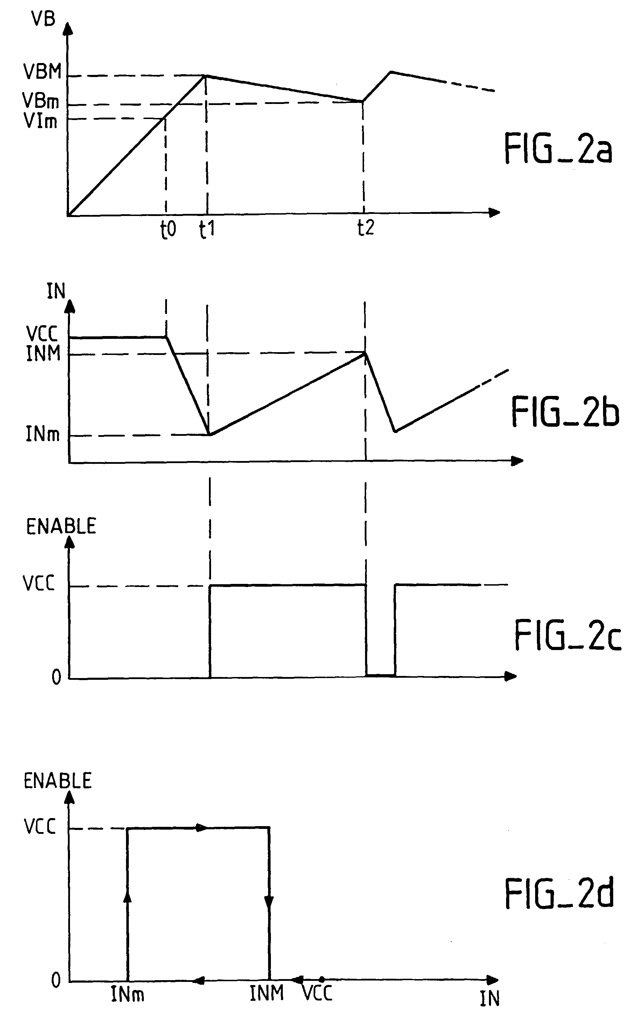

La figure 2a illustre l'évolution de la tension interne en fonction de VB. Quand VB augmente et atteint à un instant t₀, un seuil VIm, un courant commence à circuler dans la branche résistive. La tension de référence IN (illustrée figure 2b) initialement à VCC, commence à chuter.

A un instant ultérieur t₁, IN atteint la valeur INm. Les transistors de type P 22 et 23 du comparateur deviennent passants et le signal ENABLE (illustré figure 2c), initialement à 0, va passer à 1. La pompe de charge sera donc arrêtée. La tension ne pourra donc pas dépasser la valeur VBM correspondant à cet instant t₁.

Si la valeur de VB chute, la tension de référence IN va remonter. En supposant qu'elle atteigne à un instant t₂ la valeur INM, les transistors de type N 24 et 25 du comparateur vont devenir passants et le signal ENABLE va passer à 0, provoquant le démarrage de la pompe de charge et l'augmentation de VB.

L'hystérésis de tension produit est illustré figure 2d, cette figure montrant l'évolution du signal ENABLE en fonction de la tension de référence IN.

La description ci-dessus est donnée à titre indicatif et nullement limitatif. Ainsi, on aurait pu remplacer les transistors de type P 11 et 12 de la branche résistive par un transistor de type P faisant office de résistance, d'une manière analogue au transistor de référence 19. Néanmoins, ceci aurait l'inconvénient d'augmenter la consommation de cette branche et de réduire ainsi l'efficacité de la pompe de charge. De même on pourra se passer des transistors d'isolation et remplacer la porte NON OU 28 par un inverseur si on ne souhaite pas proposer de mode basse consommation.

## Revendications

1. Circuit intégré comprenant un circuit d'alimentation (4) fournissant sur une sortie (29) une tension interne (VB), et un circuit de limitation de tension, caractérisé en ce que le circuit de limitation de tension comprend :
- des moyens résistifs (13, 15, 16, 17) pour produire un courant de référence (kI) proportionnel à la tension interne,
- une source de tension commandée en courant pour produire une tension de référence (IN) proportionnelle au courant de référence,
- un comparateur à hystérésis (20) recevant la tension de référence sur une entrée (21) et fournissant un signal binaire (ENABLE) sur une sortie tel que ce signal passe dans un premier état quand la tension interne atteint une valeur maximale (VBM) et que ce signal passe dans un second état si la tension interne atteint ultérieurement une valeur minimale (VBm).

2. Circuit selon la revendication 1, caractérisé en ce que les moyens résistifs comportent une résistance connectée à la sortie du circuit d'alimentation, un premier transistor d'amplification (13) monté en série entre cette résistance et une borne de référence (3), et un deuxième transistor d'amplification (15) formant avec le premier transistor d'amplification un miroir de courant pour produire le courant de référence de telle manière que celui-ci soit proportionnel au courant traversant la résistance.

3. Circuit selon la revendication 1, caractérisé en ce que les moyens résistifs comportent un premier et un deuxième transistors de type P (16, 17) montés en série entre la sortie du circuit d'alimentation et un premier transistor d'amplification, le premier transistor de type P ayant sa grille de commande connectée à son drain, le deuxième transistor de type P ayant sa grille de commande connectée à une borne d'alimentation, et en ce qu'ils comportent un deuxième transistor d'amplification formant, avec le premier transistor d'amplification, un miroir de courant pour produire le courant de référence de telle manière que celui-ci soit proportionnel au courant traversant la résistance.

4. Circuit selon l'une des revendications 1 à 3, caractérisé en ce que la source de tension de référence comporte au moins une résistance de référence (19) montée en série entre une borne d'alimentation (2) et le deuxième transistor d'amplification.

5. Circuit selon la revendication 4, caractérisé en ce que la résistance de référence est réalisée à l'aide d'un transistor de type P résistif (19) dont la grille de commande est connectée à la borne de référence.

6. Circuit selon la revendication 4, caractérisé en ce que le comparateur à hystérésis a son entrée connectée au point milieu du deuxième transistor d'amplification et de la résistance de référence.

7. Circuit selon l'une des revendications 1 à 6, caractérisée en ce qu'il comporte des moyens de commande pour maintenir le signal binaire dans son deuxième état quelle que soit la valeur de tension interne, quand un signal binaire de commande de limitation (PWD) est dans un premier état.

8. Circuit selon la revendication 7, caractérisé en ce qu'il comporte des moyens pour annuler les courants traversant les transistors d'amplification du miroir de courant quand le signal de commande est dans sont premier état.

9. Circuit selon l'une des revendications 7 à 8, caractérisé en ce que le circuit d'alimentation est un multiplicateur de tension qui comporte une entrée pour recevoir un signal de commande, de telle manière que la tension interne soit maintenue entre sa valeur maximale et la valeur minimale quand le signal de commande de limitation est dans son deuxième état.

## Patentansprüche

1. Integrieter Schaltkreis mit einem Versorgungsschaltkreis (4), der über einen Ausgang (29) eine interne Spannung (VB) bereitstellt, und einem Spannungsbegrenzerschaltkreis,
**dadurch gekennzeichnet**, daß
der Spannungsbegrenzerschaltkreis umfaßt:
- Widerstandseinrichtungen (13, 15, 16, 17) zum Erzeugen eines Referenzstroms (kI), der proportional zur internen Spannung ist,
- eine Spannungsquelle, die stromgesteuert ist, um eine Referenzspannung (IN) zu erzeugen, die proportional zum Referenzstrom ist,
- einen Komparator mit Hysterese (20), an dessen einem Eingang (21) die Referenzspannung anliegt und der ein Binarsignai (Enable) auf einen Ausgang ausgibt, so daß das Signal sich in einem ersten Zustand befindet, wenn die interne Spannung einen Maximalwert (VBM) einnimmt und das Signal sich in einem zweiten Zustand befindet, wenn die interne Spannung nachträglich einen Minimalwert (VBm) einnimmt.

2. Schaltkreis nach Anspruch 1, dadurch gekennzeichnet, daß die Widerstandsvorrichtungen einen Widerstand, der mit dem Ausgang des Versorgungsschaltkreises verbunden ist, einen ersten Verstärkungstransistor (13), geschaltet in Serie zwischen dem Widerstand und einem Referenzanschluß (3) und einen zweiten Verstärkungstransistor (15) umfassen, der zusammen mit dem ersten Verstärkungstransistor einen Stromspiegel zum Erzeugen des Referenzstroms bildet, so daß dieser porportional zu dem Strom ist, der durch den Widerstand fließt.

3. Schaltkreis nach Anspruch 1, dadurch gekennzeichnet, daß die Widerstandsvorrichtungen einen ersten und einen zweiten P-Typ-Transistor (16, 17) umfassen, geschaltet in Serie zwischen dem Ausgang des Versorgungsschaltkreises und einem ersten Verstärkungstransistor, wobei der Steuereingang des ersten P-Typ-Transistors mit seinem drain verbunden ist, der Steuereingang des zweiten P-Typ-Transistors mit seinem Versorgungsanschluß verbunden ist, und dadurch, daß sie einen zweiten Verstärkungstransistor umfassen, der mit dem ersten Verstärkungstransistor einen Stromspiegel zu Erzeugen des Referenzstroms bildet, so daß dieser proportional zu dem Strom ist, der durch den Widerstand fließt.

4. Schaltkreis nach einem der Ansprüche 1 bis 3, dadurch gekennzeichnet, daß die Referenzspannungsquelle wenigstens einen Referenzwiderstand (19) in Serie zwischen einem Versorgungsanschluß (2) und dem zweiten Verstärkungstransistor umfaßt.

5. Schalkreis nach Anspruch 4, dadurch gekennzeichnet, daß der Referenzwiderstand gebildet wird mit Hilfe eines resistiven P-Typ-Transistors (19), dessen Steueranschluß verbunden ist mit dem Referenzanschluß.

6. Schaltkreis nach Anspruch 4, dadurch gekennzeichnet, daß der Eingag des Komparators mit Hysterese mit einem Punkt zwischen dem zweiten Verstärkungstransistor und dem Referenzwiderstand verbunden ist.

7. Schaltkreis nach einem der Ansprüche 1 bis 6, dadurch gekennzeichnet, daß er Steuervorrichtungen für das Aufrechterhalten des Binärsignals im zweiten Zustand unabhängig vom Wert der internen Spannung umfaßt, wenn ein Binärsignal zur Begrenzung (PWD) sich im ersten Zustand befindet.

8. Schaltkreis nach Anspruch 7, dadurch gekennzeichnet, daß er Vorrichtungen zum Kompensieren der Ströme umfaßt, die durch die Verstärkungstransistoren des Stromspiegels fließen, wenn das Steuersignal sich in seinem ersten Zustand befindet.

9. Schaltkreis nach einem der Ansprüche 7 oder 8, dadurch gekennzeichnet, daß der Versorgungsschaltkreis ein Spannungsmultiplizierer ist, der einen Eingang für ein Steuersignal umfaßt, so daß die interne Spannung zwischen ihrem Maximalwert und ihrem Minimalwert gehalten wird, wenn das Steuersignal zur Begrenzung sich in seinem zweiten Zustand befindet.

## Claims

1. Integrated circuit comprising a power supply circuit (4) supplying an internal voltage (VB) at an output (29), and a voltage limitation circuit, characterised in that the voltage limitation circuit comprises:
- resistive means (13, 15, 16, 17) for producing a reference current (kI) proportional to the internal voltage,
- a current-controlled voltage source for producing a reference voltage (IN) proportional to the reference current,
- a hysteresis comparator (20) receiving the reference voltage at an input (21) and supplying a binary signal (ENABLE) at an output such that this signal goes to a first state when the internal voltage reaches a maximum value (VBM) and such that this signal goes to a second state if the internal voltage subsequently attains a minimum value (VBm).

2. Circuit according to Claim 1, characterised in that the resistive means include a resistance connected to the output of the power supply circuit, a first amplification transistor (13) connected in series between this resistance and a reference terminal (3), and a second amplification transistor (15) forming with the first amplification transistor a current mirror to produce the reference current so that the latter is proportional to the current passing through the resistance.

3. Circuit according to Claim 1, characterised in that the resistive means include first and second p-type transistors (16, 17) connected in series between the output of the power supply circuit and a first amplification transistor, the first p-type transistor having its control gate connected to its drain, the second p-type transistor having its control gate connected to a supply terminal, and in that they include a second amplification transistor forming, with the first amplification transistor, a current mirror to produce the reference current so that the latter is proportional to the current passing through the resistance.

4. Circuit according to one of Claims 1 to 3, characterised in that the reference voltage source includes at least one reference resistance (19) connected in series between a supply terminal (2) and the second amplification transistor.

5. Circuit according to Claim 4, characterised in that the reference resistance is produced using a resistive p-type transistor (19) whose control gate is connected to the reference terminal.

6. Circuit according to Claim 4, characterised in that the hysteresis comparator has its input connected to the mid-point of the second amplification transistor and reference resistance.

7. Circuit according to one of Claims 1 to 6, characterised in that it includes control means for keeping the binary signal in its second state whatever the internal voltage value, when a binary limitation control signal (PWD) is in a first state.

8. Circuit according to Claim 7, characterised in that it includes means of cancelling the currents passing through the amplification transistors of the current mirror when the control signal is in its first state.

9. Circuit according to one of Claims 7 to 8, characterised in that the supply circuit is a voltage multiplier including an input for receiving a control signal, so that the internal voltage is kept between its maximum value and the minimum value when the limitation control signal is in its second state.
